Europäisches Patentamt

(19) European Patent Office

Office européen des brevets

(11) Numéro de publication: **0 230 824 B1**

(12) **FASCICULE DE BREVET EUROPEEN**

(51) Int. Cl.⁵: **H01L 21/82, H01L 21/76**

(45) Date de publication du fascicule du brevet: **23.05.90**

(21) Numéro de dépôt: **86402846.9**

(22) Date de dépôt: **17.12.86**

(54) **Procédé de fabrication d'un caisson et éventuellement de zones d'isolation électriques d'un circuit intégré, notamment de type MOS.**

(30) Priorité: **18.12.85 FR 8518771**

(43) Date de publication de la demande:
**05.08.87 Bulletin 87/32**

(45) Mention de la délivrance du brevet:
**23.05.90 Bulletin 90/21**

(84) Etats contractants désignés:
**DE FR GB IT NL**

(56) Documents cités:
**FR-A- 2 472 267**
**GB-A- 2 090 062**

**NEUES AUS DER TECHNIK,**
**no. 1/2, 15 avril 1983, page 1, Würzburg, DE; "Verfahren zur Bildung einer CMOST-Struktur"**
**IBM TECHNICAL DISCLOSURE BULLETIN,**
**vol. 26, no. 3B, août 1983, New York, US; S. OGURA et al.: "Latch-up free CMOS structure"**

(73) Titulaire: **Bois, Daniel, 9, rue de la Grange, F-38240 Meylan(FR)**

(72) Inventeur: **Bois, Daniel, 9, rue de la Grange, F-38240 Meylan(FR)**

(74) Mandataire: **Mongrédien, André et al, c/o BREVATOME 25, rue de Ponthieu, F-75008 Paris(FR)**

## Description

La présente invention a pour objet un procédé de fabrication d'un caisson dans un substrat, de conductivité différente de celle du substrat, et éventuellement de zones d'isolation électriques servant à isoler les composants actifs d'un circuit intégré les uns des autres.

Ce procédé peut être utilisé dans le domaine de la microélectronique chaque fois que l'on désire modifier la conductivité d'une région d'un substrat semiconducteur en vue d'y réaliser des composants actifs particuliers et que l'on souhaite isoler électriquement les uns des autres les composants actifs réalisés dans ce substrat semi-conducteur. Les composants actifs peuvent être des transistors, des diodes, des dispositifs à transfert de charge, etc...

En particulier, l'invention s'applique aux circuits intégrés utilisant le silicium monocristallin comme substrat, tels que les circuits intégrés MOS ou bipolaires et plus spécialement les circuits intégrés CMOS, comportant à la fois des transistors à canal n et des transistors à canal p.

Comme procédés de fabrication d'un caisson et de zones d'isolation électriques d'un circuit intégré actuellement connu, on peut notamment citer ceux décrits dans l'ouvrage "Semiconductor technology handbook" publié le 15 avril 1982 par TECHNOLOGY ASSOCIATES.

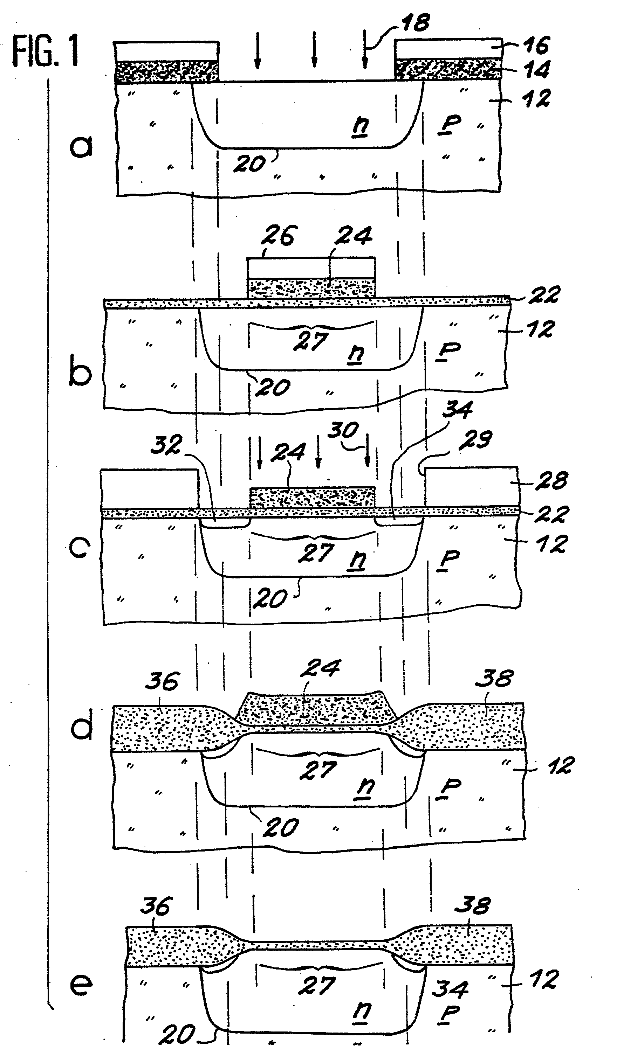

Sur la figure 1 annexée, on a schématisé en coupe longitudinale, les principales étapes d'un procédé connu de fabrication d'un caisson et de zones d'isolations électriques d'un circuit intégré MOS ; les parties a-e de la figure 1 représentent différents stades de la fabrication. Le caisson est destiné à recevoir un transistor MOS du circuit.

La première étape de ce procédé connu consiste, comme représenté sur la partie a de la figure 1, à faire croître thermiquement sur un substrat en silicium monocristallin 12 de type p, une couche d'oxyde de silicium 14 présentant une épaisseur de l'ordre de 1 µm. Par photolithographie, on réalise ensuite un masque de résine photosensible 16, représentant l'image du caisson n à réaliser dans le substrat 12. Ensuite, on élimine les régions de la couche d'oxyde de silicium 14 non masquées par la résine 6 puis on dissout la résine.

On effectue alors une implantation d'ions de phosphore 18 suivie d'un recuit à haute température de l'ordre de 1000 °C afin de permettre la diffusion des ions de phosphore dans le substrat 12 et former ainsi un caisson 20 de type n. La couche d'oxyde 14 gravée sert de masque à cette implantation.

Après élimination de la couche d'oxyde 14, comme représenté sur la partie b de la figure 1, on fait croître thermiquement une couche d'oxyde de silicium 22 de faible épaisseur, notamment de l'ordre de 0,01 µm, dans lequel sera réalisé ultérieurement l'oxyde de grille du transistor logé dans le caisson 20. On dépose ensuite une couche de nitrure de silicium 24 d'environ 0,08 µm sur laquelle on réalise un masque de résine 26 par photolithographie. Ce masque 26 recouvre uniquement la région du substrat 27 dans laquelle sera réalisé ultérieurement le transistor du circuit intégré logé dans le caisson 20 ; le masque de résine 26 est centré au-dessus du caisson.

On effectue ensuite l'élimination des régions de la couche de nitrure 24 non recouvertes de résine. Après dissolution du masque de résine 26, on réalise un autre masque de résine photosensible 28, comme représenté sur la partie c de la figure 1. Ce masque de résine 28 comporte une ouverture 29 dont le diamètre est égal au diamètre maximum du caisson 20.

On effectue ensuite une implantation 30 d'ions d'arsenic dans le caisson 20, la résine 28 et la couche de nitrure de silicium gravée 24 servant de masque à cette implantation. On forme ainsi deux régions latérales 32 et 34 de type n$^+$ dans le caisson 20.

Après élimination du masque de résine 28, comme représenté sur la partie d de la figure 1, on réalise deux isolations électriques 36 et 38, situées de part et d'autre de la région 27 du substrat dans laquelle sera réalisé le transistor du circuit intégré. Ces isolations latérales sont obtenues par oxydation thermique localisées des régions du substrat en silicium non recouvertes de la couche de nitrure gravée 24, cette oxydation se faisant à une température supérieure à 900°C. Cette technique d'isolation est appelée technique LOCOS. Les deux régions d'oxyde de silicium obtenues 36 et 38 présentent une épaisseur généralement comprise entre 0,6 et 1,0 µm.

Le procédé de fabrication connu d'un caisson et de zones d'isolations se termine en éliminant le restant de la couche de nitrure. La structure finale obtenue est celle représentée sur la partie e de la figure 1.

Ce procédé de fabrication bien que couramment utilisé présente un certain nombre d'inconvénients.

En particulier, ce procédé comporte un grand nombre d'étapes critiques telles que les étapes de fabrication des trois masques de résine 16, 26, 28 par photolithographie et deux étapes de traitement thermique, celle après l'implantation de phosphore et celle lors de la réalisation du LOCOS. Ces étapes de masquage et de traitement thermique présentent l'inconvénient majeur de limiter la densité d'intégration des circuits intégrés.

En effet, le positionnement correct des masques de résine est critique, ce qui nécessite l'emploi de marges de tolérance dans leur positionnement latéral ; en particulier le centrage du masque 26, définissant l'emplacement et les dimensions du transistor à réaliser dans le caisson, au-dessus du caisson et l'alignement des côtés de l'ouverture 29 du masque 28 avec ceux du caisson sont difficiles à réaliser. De même, les traitements thermiques distincts conduisent à une diffusion latérale trop importante des ions implantés.

Afin de faciliter le positionnement du composant actif dans le caisson, on a envisagé, comme décrit dans l'article "Neues aus der Technik" n° 1/2, 15 avril 1983, page 1, Vogel-Verlag, Würzburg DE, intitulé "Verfahren zur Bildung einer CMOST-Struktur", de définir l'emplacement du caisson après avoir défini l'emplacement du composant.

Toutefois, dans ce procédé, la diffusion latérale des ions implantés dans le substrat, lors des traitements thermiques ultérieurs, subsiste limitant encore la densité d'intégration des circuits intégrés.

La présente invention a justement pour objet un procédé de fabrication d'un caisson et éventuellement de zones d'isolation électriques dans un circuit intégré, notamment de type MOS, permettant de remédier aux différents inconvénients ci-dessus. En particulier, ce procédé permet d'augmenter la densité d'intégration des circuits intégrés, en évitant la diffusion latérale des ions implantés dans le substrat, tout en facilitant le positionnement des composants actifs dans les caissons.

De façon plus précise, l'invention a pour objet un premier procédé de fabrication d'un caisson d'un premier type de conductivité dans un substrat semiconducteur d'un second type de conductivité, ce caisson étant destiné à recevoir au moins un composant actif d'un circuit intégré réalisé dans ledit substrat, selon la revendication 1.

Ce premier procédé selon l'invention permet, en plus de la fabrication d'un caisson, la fabrication de zones d'isolation électriques adjacentes aux composants actifs logés dans le caisson. Ces zones d'isolation sont formées entre l'élimination du second matériau et l'élimination du premier matériau.

De façon avantageuse, on forme les zones d'isolation successivement au recuit, par oxydation thermique des régions du substrat non recouvertes du premier matériau restant, pour un substrat en silicium.

La réalisation successive du recuit du substrat, pour faire diffuser les ions, et de l'oxydation thermique de ce substrat, pour former les zones d'isolation, permet de limiter la diffusion latérale des ions implantés dans le substrat. En effet, tout se passe comme si la structure semi-conductrice n'était soumise qu'à un seul traitement thermique.

Bien que l'invention s'applique plus spécialement aux substrats en silicium, elle s'applique aussi à tout substrat semi-conducteur comme par exemple les substrats en GaAs et InP.

La réalisation selon l'invention, d'une gravure partielle des régions du substrat non masquées par le premier et second matériaux, entre les deux implantations ioniques, permet de supprimer la diffusion latérale des ions implantés permettant en particulier de raccourcir notablement la distance séparant les zones d'isolation électrique et par conséquent d'augmenter la densité d'intégration des circuits intégrés de façon importante.

L'implantation de la seconde sorte d'ions permet en particulier de diminuer la résistance moyenne latérale du caisson et donc d'éviter le phénomène de "transistor parasite vertical" connu sous le nom de "latch up" en terminologie anglo-saxonne.

Les ions de première et seconde sortes utilisables dans le premier procédé de l'invention sont des ions permettant de changer le type de conductivité du substrat. Par ailleurs, les ions de la première sorte sont des ions dont la profondeur de pénétration dans un matériau donné est inférieure à celle des ions de la seconde sorte.

Dans le cas d'un substrat en silicium de type p, les ions de la première sorte sont avantageusement des ions de phosphore et les ions de la seconde sorte des ions d'arsenic.

De même, dans le cas d'un substrat en silicium de type n, les ions de la première sorte sont des ions de bore et les ions de la seconde sorte sont des ions de difluorure de bore ($BF_2$).

L'invention a aussi pour objet un second procédé de fabrication d'un caisson d'un premier type de conductivité et de zones d'isolation électrique dans un substrat semi-conducteur d'un second type de conductivité, à l'aide de l'implantation de trois sortes d'ions, ce caisson étant destiné à recevoir au moins un premier composant actif d'un circuit intégré réalisé dans ledit substrat et les zones d'isolation, adjacentes audit premier composant, étant destinées à isoler électriquement ce premier composant d'au moins un second composant actif dudit circuit intégré, selon la revendications 10.

Comme précédemment, la gravure partielle des secondes régions du substrat, conformément au second procédé, permet de supprimer la diffusion latérale des ions implantés, et donc de raccourcir la distance séparant les zones d'isolation et par conséquent d'augmenter la densité d'intégration des circuits intégrés.

Les ions de la troisième sorte utilisables dans le second procédé selon l'invention sont des ions qui ne changent pas le type de conductivité du substrat.

Dans le cas d'un substrat en silicium de type n, les ions de la troisième sorte sont des ions d'arsenic. De même, dans le cas d'un substrat en silicium de type p, les ions de la troisième sorte sont des ions de difluorure de bore.

En revanche, les ions des première et seconde sortes utilisables dans ce second procédé sont des ions permettant de changer le type de conductivité du substrat. En outre, la profondeur de pénétration des ions de la seconde sorte dans un matériau donné est inférieure à celle des ions de la première sorte.

Pour un substrat en silicium de type p, les ions des première et seconde sortes sont respectivement des ions de phosphore et d'arsenic. Pour un substrat en silicium de type n, les ions des première et seconde sortes sont des ions respectivement de bore et de $BF_2$.

Les procédés selon l'invention ne sont nullement critique en ce qui concerne le positionnement correct du composant actif dans le caisson, étant donné que le caisson est réalisé après définition de l'emplacement du composant ; le premier matériau restant servant à cette définition, faisant saillie hors du substrat, permet un repérage aisé. De plus, ils permettent de n'utiliser qu'un seul masque pour réaliser deux implantations successives d'ions de sortes différentes.

Comme premier et second matériaux on peut utiliser tout matériau pouvant être gravé sélectivement par rapport au matériau sous-jacent.

De préférence, le premier matériau est du nitrure de silicium et le second matériau une résine photosensible, positive ou négative.

Selon un mode préféré de mise en oeuvre des procédés selon l'invention, la gravure partielle des régions non masquées par le premier matériau gravé et le second matériau du substrat est réalisée sur une hauteur au moins égale à la profondeur de pénétration des ions de la première sorte, respectivement de la troisième sorte, dans le substrat, lors de leur implantation.

Les procédés selon l'invention s'appliquent avantageusement à la fabrication d'un circuit intégré MOS, et notamment de type CMOS, dans un substrat en silicium. Dans ce cas, on interpose entre la couche de premier matériau et le substrat une couche d'oxyde de silicium dans laquelle sera réalisé ultérieurement l'oxyde de grille du composant actif logé dans le caisson.

Dans cette application particulière, il est nécessaire d'éliminer les régions de la couche d'oxyde de silicium non masquées par le premier matériau restant et le second matériau, avant de réaliser la gravure du substrat.

D'autres caractéristiques et avantages de l'invention ressortiront mieux de la description qui va suivre, donnée à titre illustratif et non limitatif en référence aux figures annexées, dans lesquelles :

- la figure 2 illustre en coupe longitudinale, les différentes étapes d'un premier procédé de fabrication d'un caisson et de zones d'isolation électrique d'un circuit intégré, conformement à l'invention, les parties a-d de cette figure 2 représentant différents stades de ce procédé, et

- la figure 3 représente, en coupe longitudinale, les différentes étapes d'un second procédé de fabrication d'un caisson et de zones d'isolation électrique d'un circuit intégré, conformément à l'invention, les parties a-d correspondant à différents stades de ce procédé.

La description ci-après se réfère à la fabrication d'un circuit intégré MOS dans un substrat semiconducteur en silicium monocristallin de type p. Mais bien entendu, comme on l'a vu précédemment, le procédé selon l'invention est d'application beaucoup plus générale.

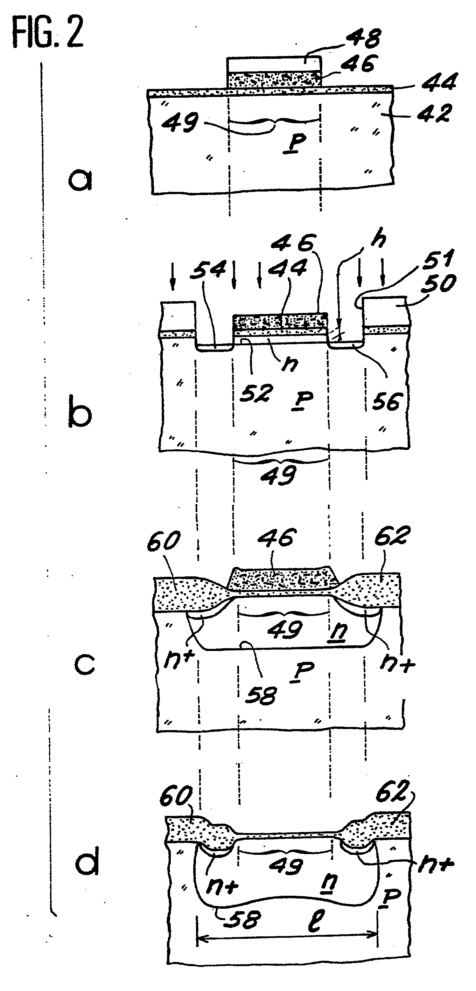

En se référant à la partie a de la figure 2, la première étape du premier procédé selon l'invention consiste à former sur un substrat en silicium monocristallin de type p 42 une couche d'oxyde de silicium 44 d'environ 15 nm d'épaisseur. Cette couche d'oxyde de silicium 44 est obtenue par oxydation thermique du substrat, sous une atmosphère d'oxygène, à une température de l'ordre de 950°C.

Sur cette couche d'oxyde de silicium 44, on dépose ensuite une couche 46 d'un matériau pouvant être gravé sélectivement par rapport à l'oxyde de silicium. Cette couche 46 est par exemple une couche de nitrure de silicium d'environ 80 nm. Elle peut être déposée par un procédé de dépôt chimique en phase vapeur, à 800° C à partir d'un gaz contenant du $SiH_4$ et du $N_2$.

On réalise ensuite par les procédés classiques de photolithographie un masque de résine photosensible 48 représentant l'image du composant actif à réaliser à l'intérieur du caisson. En particulier, la résine ne masque que la zone 49 du substrat dans laquelle sera réalisé le composant actif logé dans le caisson.

On élimine ensuite les régions de la couche de nitrure de silicium 46 non recouvertes de résine 48. Cette élimination est réalisée par une gravure plasma du type ionique réactive avec de l'hexafluorure de soufre comme agent de gravure.

Après élimination du masque de résine 48, par dissolution dans l'acétone, on forme un second masque de résine 50 par les procédés classiques de photolithographie. Ce masque 50, comme représenté sur la partie b de la figure 2 représente l'image du caisson n à réaliser dans le substrat 42 de type p. En particulier, ce masque 50 comporte une ouverture 51 délimitant le caisson n à réaliser ; cette ouverture 51 est située en regard du plot restant de la couche 46 et déborde de chaque côté de ce plot.

On réalise ensuite une implantation ionique de phosphore à travers la couche de nitrure 46 gravée et l'oxyde de silicium 44, pour former une région 52 de type n. La résine 50 sert de masque à cette implantation de phosphore ; autrement dit les ions de phosphore pénètrent dans la zone 49 du substrat située en-dessous du nitrure de silicium gravé 46 et dans les régions du substrat adjacentes à cette zone et non masquées par le nitrure de silicium et la résine 50. Cette implantation de phosphore peut être réalisée à une énergie de 200 keV et à une dose allant de $10^{12}$ à $10^{13}$ atomes/cm².

On réalise alors, juste après l'implantation ionique de phosphore, l'élimination des régions de la couche d'oxyde 44 non recouvertes par le masque de résine 50 et la couche de nitrure de silicium gravée 46. Cette élimination peut être effectuée par une gravure plasma du type ionique réactive en utilisant du $CHF_3$ comme agent de gravure.

Ensuite, on effectue une gravure sur une hauteur h des régions du substrat mises à nu, c'est-à-dire des régions non recouvertes de la résine 50 et de la couche 46 gravée. La profondeur h de la gravure est égale à la profondeur de pénétration des ions de phosphore dans le substrat, lors de leur implantation. En particulier la hauteur h est voisine de 200 nm pour une énergie d'implantation de 200 keV. La gravure du substrat peut être réalisée par une gravure plasma du type gravure ionique réactive en utilisant comme agent d'attaque de l'hexafluorure de soufre.

Cette gravure du substrat permet de supprimer la diffusion latérale des ions de phosphore implantés.

On effectue ensuite une implantation d'ions d'arsenic entraînant la formation de deux régions latérales 54 et 56 de type n⁺ dans la région n 52 adjacentes à la zone 49 et situées en contre-bas de la région 52. Cette implantation d'arsenic est réalisée en utilisant comme masque d'implantation le masque de résine 50 et la couche de nitrure 46 gravée. Elle est effectuée avec une énergie de 80 keV et à une dose allant de $10^{13}$ à $10^{14}$ atomes/cm².

Les régions 54 et 56 de type n⁺ servent à améliorer l'isolation latérale du composant actif (transistor) à réaliser dans la zone 49 du substrat ainsi qu'à diminuer la résistance d'accès dans le caisson 58, améliorant ainsi le "latch up".

La différence de profondeur de pénétration dans le substrat entre le phosphore et l'arsenic, ce dernier ne pénétrant pas dans la zone 49 du substrat à l'inverse du phosphore, est liée aux différences de taille des atomes correspondants ; l'atome de phosphore étant plus petit que l'atome d'arsenic pénètre plus profondément dans tous les matériaux et en particulier dans le silicium.

L'étape suivante du procédé consiste à éliminer le masque de résine 50 notamment par dissolution dans de l'acétone. On effectue ensuite un recuit du substrat implanté afin de faire diffuser les ions de phosphore dans le substrat pour former, comme représenté sur la partie c de la figure 2, le caisson n 58, cette diffusion de phosphore s'accompagne d'une faible diffusion des ions d'arsenic implantés. Le recuit est réalisé à une température de 1150°C pendant quelques heures (2-4 heures) sous atmosphère d'azote.

Consécutivement au recuit, on effectue une oxydation thermique des régions du substrat non recouvertes de la couche nitrure de silicium 46 gravée afin de former deux isolations latérales électriques 60 et 62, situées de part et d'autre de la région 49 dans laquelle sera réalisé ultérieurement le composant actif. Les deux régions d'oxyde de silicium 60 et 62 sont obtenues en chauffant le substrat à 1000° C pendant quelques heures (2-3 heures) dans une atmosphère d'oxygène et de vapeur d'eau. L'épaisseur de l'oxyde localisé obtenu est de 800 nm.

Suite à ce traitement thermique, recuit plus oxydation, la hauteur du caisson n 58 obtenue est d'environ 3000 nm.

La dernière étape du procédé consiste à éliminer la couche de nitrure de silicium 46 gravée, notamment par une attaque plasma avec de l'hexafluorure de soufre. La structure finale obtenue est représentée sur la partie d de la figure 2.

Ce procédé est destiné à limiter l'extension latérale du caisson n 58 entraînant ainsi une diminution de la longueur I séparant les deux zones d'isolation 60 et 62, et donc une augmentation de la densité d'intégration du circuit intégré correspondant.

En effet, la gravure du substrat permet d'enlever les régions de ce substrat implantées en phosphore, situées autour de la région 49 dans laquelle doit être réalisé le composant actif ou autrement dit les régions du substrat non masquées par la couche de nitrure 46 gravée.

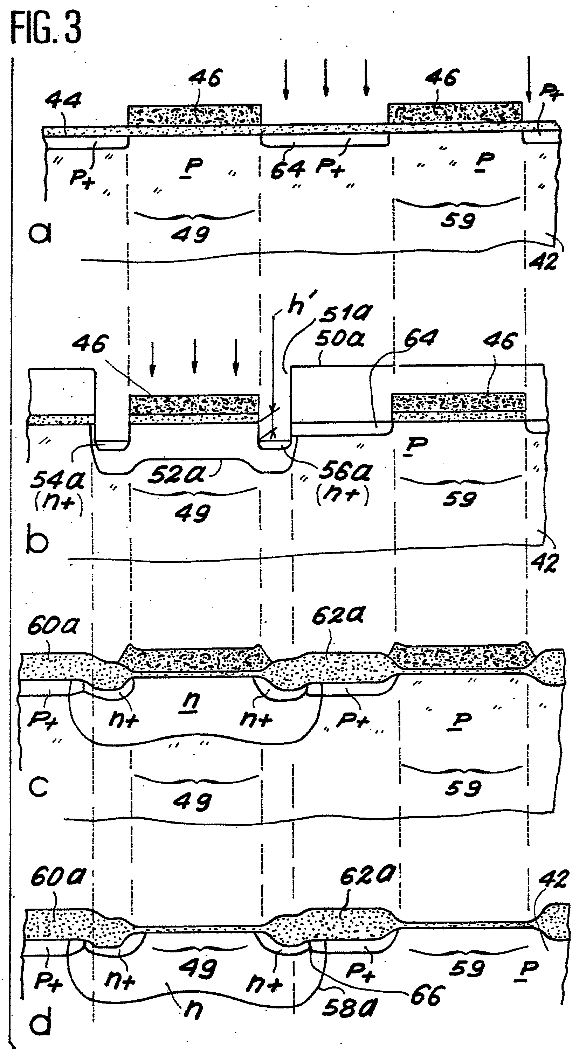

Sur la figure 3, on a représenté un second procédé selon l'invention. Ce procédé est décrit dans le cas de la réalisation de deux composants actifs isolés électriquement l'un de l'autre, l'un des composants devant être réalisé dans le caisson n, l'autre en-dehors dudit caisson.

Ce procédé consiste, après dépôt de la couche d'oxyde 44 sur l'ensemble du substrat 42, à déposer une couche de nitrure 46, puis à graver cette couche afin de ne garder du nitrure qu'au-dessus des zones du substrat 49 et 59, dans chacune desquelles sera réalisé un composant actif du circuit intégré, comme représenté sur la partie a de la figure 3. Le dépôt et la gravure de cette couche 46 sont réalisés dans les mêmes conditions que précédemment (figure 2.a). La zone du substrat 49 sera logée ultérieurement dans un caisson n.

On effectue ensuite une implantation ionique d'ions de difluorure de bore dans les régions du substrat non masquées par la couche 46 gravée. Cette implantation de $BF_2$ peut être réalisée avec une énergie de 30 keV et à une dose allant de $10^{13}$ à $10^{14}$ atomes/cm². 

On réalise ensuite, comme représenté sur la partie b de la figure 3, un masque de résine 50a selon les procédés classiques de photolithographie, représentant l'image du caisson n à réaliser. En particulier, ce masque comporte une ouverture 51a, située en regard de la zone 49 du substrat et débordant de part et d'autre de cette zone, délimitant les dimensions du caisson n à réaliser. En outre, les régions 59 du substrat sont masquées par la résine.

On élimine ensuite les régions de la couche d'oxyde 44 non recouvertes par le masque de résine 50a, le nitrure de silicium 46 gravé. Cette élimination d'oxyde est réalisée par une gravure ionique réactive avec un plasma de $CHF_3$. On effectue ensuite une gravure des régions du substrat mises à nu sur une hauteur h' supérieure ou égale à la profondeur de pénétration, dans le silicium, des ions de difluorure de bore implantés. Cette hauteur h' est voisine de 50 nm pour une énergie d'implantation de 30 keV.

Comme précédemment, on effectue ensuite à travers le masque de résine 50a une implantation d'ions de phosphore donnant naissance à une région de type n 52a, cette implantation étant réalisée avec une énergie de 400 keV et une dose allant de $10^{12}$ à $10^{13}$ atomes/cm². On réalise ensuite l'implantation d'ions d'arsenic, dans les mêmes conditions que précédemment, donnant naissance aux deux régions latérales n⁺ 54a et 56a.

Après élimination du masque de résine 50a par dissolution avec de l'acétone, on effectue un recuit à une température de l'ordre de 950° C pendant 30 min., entraînant la diffusion des ions de phosphore implantés et par conséquent la formation d'un caisson n 58a, comme représenté sur la partie c de la figure 3.

On effectue ensuite sous atmosphère d'oxygène et de vapeur d'eau et à une température de 950° C une oxydation des régions mises à nu du substrat pour former les zones d'isolation électrique 60a et 62a. Ces zones d'isolation ont une épaisseur de 0,8 µm.

On élimine ensuite la couche de nitrure de silicium gravée. La structure finale est représentée sur la partie d de la figure 3.

Sur cette figure, la région 66 du substrat, qui constitue une juxtaposition de zones n⁺ et p⁺, est entourée par le caisson n. Cette région 66 est très efficace pour éviter le phénomène de "transistor parasite vertical" ou phénomène de "latch up" en terminologie anglo-saxonne.

Dans ce second procédé, les régions de type n⁺, p⁺ et n se positionnent automatiquement les unes par rapport aux autres.

Les procédés selon l'invention présentent l'avantage d'être plus simple que ceux de l'art antérieur du fait de la suppression d'étapes critiques telles que les réalisations de masques de résine par photolithographie. Par ailleurs, ils sont bien adaptés à la fabrication de circuits CMOS.

La description donnée précédemment n'a bien entendu été donnée qu'à titre illustratif, toute modification, sans pour autant sortir du cadre de l'invention, pouvant être envisagée.

En particulier, la nature et l'épaisseur des différentes couches de matériau ainsi que leurs techniques de dépôt et de gravure peuvent être modifiées. La couche d'oxyde 44 peut notamment être remplacée par une couche de nitrure de silicium et la couche de nitrure de silicium 46 par de l'oxyde de silicium ou du sulfure de zinc. De même, le substrat de type p peut être remplacé par un substrat de type n; dans ces conditions, les implantations de phosphore, d'arsenic et de difluorure de bore seront remplacées respectivement par des implantations de bore, de difluorure de bore et d'arsenic.

## Revendications

1. Procédé de fabrication d'un caisson d'un premier type de conductivité dans un substrat (42) semi-conducteur d'un second type de conductivité, ce caisson étant destiné à recevoir au moins un composant actif d'un circuit intégré réalisé dans ledit substrat, ce procédé comprenant les étapes successives suivantes :
   (1) dépôt d'une couche d'un premier matériau (46) sur l'ensemble du substrat (42),
   (2) gravure de cette couche de premier matériau (46) afin de ne garder du premier matériau qu'au-dessus de la zone (49) du substrat dans laquelle on va realiser ledit composant actif,
   (3) réalisation d'un masque (50) en un second matériau pouvant être gravé sélectivement par rapport au matériau sous-jacent, comportant une ouverture (51) définissant les dimensions du caisson (58) à réaliser, cette ouverture (51) étant située en regard du premier matériau restant (46) et débordant de chaque côté dudit premier matériau,
   (4) implantation d'ions d'une première sorte simultanément dans ladite zone (49) du substrat et dans des régions (54, 56) du substrat adjacentes à ladite zone et non masquées par le premier matériau restant (46) et le second matériau (50), inversant localement la conductivité du substrat,
   (5) gravure partielle desdites régions (54, 56) du substrat permettant d'enlever les régions du substrat comportant des ions de la première sorte situés autour de la zone (49),
   (6) implantation d'ions d'une seconde sorte, permettant de changer le type de conductivité du substrat et dont la pénétration dans le substrat est inférieure à celle des ions de la première sorte, dans lesdites régions (54, 56) du substrat,
   (7) élimination du masque de second matériau (50),
   (8) recuit du substrat implanté pour faire diffuser les ions dans ledit substrat et former le caisson (58), et
   (9) élimination du premier matériau restant (46).

2. Procédé selon la revendication 1, caractérisé en ce que l'on réalise la gravure des régions (54a, 56a) du substrat sur une hauteur (h) égale à la profondeur de pénétration des ions de la première sorte dans le substrat, lors de leur implantation.

3. Procédé selon la revendication 1 ou 2, caractérisé en ce que les ions de la première sorte sont des ions de plus petites tailles que les ions de la seconde sorte.

4. Procédé selon l'une quelconque des revendications 1 à 3, caractérisé en ce que le substrat (42) étant du silicium de type p, les ions de la première sorte sont des ions de phosphore.

5. Procédé selon la revendication 4, caractérisé en ce que les ions de la seconde sorte sont des ions d'arsenic.

6. Procédé selon l'une quelconque des revendications 1 à 3, caractérisé en ce que le substrat (42) étant du silicium de type n, les ions de la première sorte sont des ions de bore.

7. Procédé selon la revendication 6, caractérisé en ce que les ions de la seconde sorte sont des ions de difluorure de bore.

8. Procédé selon l'une quelconque des revendications 1 à 7, servant aussi à la fabrication de zones d'isolation électrique adjacentes audit composant actif, caractérisé en ce que l'on forme lesdites zones d'isolation (60, 62) entre les étapes (7) et (9).

9. Procédé selon la revendication 8, caractérisé en ce que l'on forme les zones d'isolation (60, 62) successivement au recuit par oxydation thermique des régions du substrat non recouvertes du premier matériau restant (46), pour un substrat en silicium.

10. Procédé de fabrication d'un caisson d'un premier type de conductivité et de zones d'isolation électrique dans un substrat (42) semi-conducteur d'un second type de conductivité, à l'aide de l'implantation de trois sortes d'ions, ce caisson étant destiné à recevoir au moins un premier composant actif d'un circuit intégré réalisé dans ledit substrat et les zones d'isolation (60a, 62a), adjacentes audit premier composant, étant destinées à isoler électriquement ce premier composant d'au moins un second composant actif dudit circuit intégré, ce procédé comprenant les étapes successives suivantes :
   (1) dépôt d'une couche d'un premier matériau (46) sur l'ensemble du substrat (42),
   (2) gravure de cette couche de premier matériau (46) afin de ne garder du premier matériau qu'au-dessus des première et seconde zones (49, 50) du substrat dans lesquelles on va réaliser respectivement lesdits premier et second composants actifs,
   (3) implantation d'ions d'une troisième sorte dans des premières régions (64) du substrat non recouvertes du premier matériau (46) restant, ces premières régions présentant le second type de conductivité,
   (4) réalisation d'un masque (50a) en un second matériau, pouvant être gravé sélectivement par rapport au matériau sous-jacent, comportant une ouverture définissant les dimensions du caisson (58a) à réaliser, cette ouverture (51a) étant située en regard du premier matériau restant (46) situé au-dessus de la première zone (49) et débordant de chaque côté dudit premier matériau,
   (5) gravure partielle de secondes régions (54a, 56a) du substrat, adjacentes à la première zone (49) du substrat et non masquées par le premier matériau restant (46) et le second matériau (50a), permettant d'enlever les régions du substrat comportant des ions de la troisième sorte situées autour de la première zone (49),

(6) implantation d'ions d'une première sorte, dans la première zone (49) du substrat et dans les secondes régions (54a, 56a) du substrat, inversant localement la conductivité du substrat,

(7) implantation d'ions d'une seconde sorte, permettant de changer le type de conductivité du substrat et ayant une profondeur de pénétration dans le substrat inférieure à celle de la première sorte dans lesdites secondes régions (54a, 56a) du substrat,

(8) élimination du masque de second matériau (50a),

(9) recuit du substrat implanté pour faire diffuser les ions dans ledit substrat et former le caisson (58a),

(10) formation des zones d'isolation (60a, 62a), et

(11) élimination du premier matériau restant (46).

11. Procédé selon la revendication 10, caractérisé en ce que l'on réalise la gravure des secondes régions du substrat sur une hauteur (h') au moins égale à la profondeur de pénétration des ions de la troisième sorte dans le substrat, lors de leur implantation.

12. Procédé selon la revendication 10 ou 11, caractérisé en ce que le substrat étant du silicium de type p, les ions de la troisième sorte sont des ions de difluorure de bore.

13. Procédé selon la revendication 12, caractérisé en ce que les ions de la première sorte sont des ions de phosphore.

14. Procédé selon la revendication 12 ou 13, caractérisé en ce que les ions de la seconde sorte sont des ions d'arsenic.

15. Procédé selon la revendication 10 ou 11, caractérisé en ce que le substrat étant du silicium de type n, les ions de la troisième sorte sont des ions d'arsenic.

16. Procédé selon la revendication 15, caractérisé en ce que les ions de la première sorte sont des ions de bore.

17. Procédé selon la revendication 15, caractérisé en ce que les ions de la seconde sorte sont des ions de difluorure de bore.

18. Procédé selon l'une quelconque des revendications 1 à 17, caractérisé en ce que le premier matériau (46) est du nitrure de silicium.

19. Procédé selon l'une quelconque des revendications 1 à 17, caractérisé en ce que le second matériau (50) est de la résine photosensible.

20. Procédé selon l'une quelconque des revendications 1 à 19 appliqué à la fabrication d'un circuit intégré MOS dans un substrat en silicium, caractérisé en ce que l'on interpose entre la couche de premier matériau (46) et le substrat (42) une couche d'oxyde de silicium (44) et en ce que l'on élimine les régions de la couche d'oxyde de silicium non masquées par le premier matériau restant (46) et le second matériau (50, 50a) avant de réaliser la gravure partielle du substrat.

**Patentansprüche**

1.. Verfahren zur Herstellung einer Wanne eines ersten Leitfähigkeitstyps in einem halbleitenden Substrat (42) eines zweiten Leitfähigkeitstyps, wobei diese Wanne dazu bestimmt ist, wenigstens eine aktive Komponente eines in dem Substrat ausgeführten integrierten Schaltkreises aufzunehmen, wobei dieses Verfahren die folgenden, sukzessiven Vefahrensschritte aufweist:

1) das Aufbringen einer Schicht aus einem ersten Material (46) auf die Gesamtheit des Substrats (42),

2) das Ätzen dieser Schicht aus dem ersten Material (46), um das erste Material nur oberhalb der Zone (49) des Substrats zurückzubehalten, in der man die aktive Komponente ausführen wird,

3) das Herstellen einer Maske (50) aus einem zweiten Material, das selektiv bezüglich des darunterliegenden Materials geätzt werden kann und das eine Öffnung (51) aufweist, die die Ausmaße der herzustellenden Wanne (58) bestimmt, wobei diese Öffnung (51) gegenüber dem übriggebliebenen ersten Material (46) angeordnet ist und an jeder Seite über das erste Material herausragt,

4) die gleichzeitige Implantation von Ionen einer ersten Sorte in die Zone (49) des Substrates und in die Zonen (54, 56) des Substrats, die an besagte Zone angrenzen und nicht von dem übriggebliebenen ersten Material (46) und dem zweiten Material (50) maskiert werden, wobei lokal die Leitfähigkeit des Substrats invertiert wird,

5) das partielle Ätzen der Regionen (54, 56) des Substrats, wodurch ermöglicht wird, die Regionen des Substrats zu beseitigen, die Ionen der ersten Sorte. aufweisen und um die Zone (49) angeordnet sind,

6) die Implantation von Ionen einer zweiten Sorte, die ermöglicht, den Leitfähigkeitstyp des Substrats zu ändern, und deren Eindringtiefe in das Substrat geringer ist als die der Ionen der ersten Sorte, in die Regionen (54, 56) des Substrats,

7) das Entfernen der Maske aus dem zweiten Material,

8) das Tempern des implantierten Substrats, um die Ionen um Substrat diffundieren zu lassen und die Wanne (58) zu bilden, und

9) das Entfernen des ersten, verbliebenen Materials (46).

2. Verfahren nach Anspruch 1, dadurch gekennzeichnet, daß man das Ätzen der Regionen (54a, 56a) des Substrats bis auf eine Tiefe (h) ausführt, die gleich der Eindringtiefe der Ionen der ersten Sorte in das Substrat bei ihrer Implantation ist.

3. Verfahren nach Anspruch 1 oder 2, dadurch gekennzeichnet, daß die Ionen der ersten Sorte Ionen geringerer Größe als die Ionen der zweiten Sorte sind.

4. Verfahren nach einem der Ansprüche 1 bis 3, dadurch gekennzeichnet, daß das Substrat (42) p-dotiertes Silizium ist und die Ionen der ersten Sorte Phosphorionen sind.

5. Verfahren nach Anspruch 4, dadurch gekennzeichnet, daß die Ionen der zweiten Sorte Arsenionen sind.

6. Verfahren nach einem der Ansprüche 1 bis 3, dadurch gekennzeichnet, daß das Substrat (42) n-dotiertes Silizium ist und die Ionen der ersten Sorte Borionen sind.

7. Verfahren nach Anspruch 6, dadurch gekennzeichnet, daß die Ionen der zweiten Sorte Bordifluoridionen sind.

8. Verfahren nach einem der Ansprüche 1 bis 7, das auch zur Herstellung von elektrisch isolierenden, an die aktive Komponente angrenzenden Zonen dient, dadurch gekennzeichnet, daß man diese Isolationszonen (60, 62) zwischen den Schritten (7) und (9) bildet.

9. Verfahren nach Anspruch 8, dadurch gekennzeichnet, daß man die Isolationszonen (60, 62) nachfolgend auf das Tempern durch thermische Oxydation der nicht von dem verbliebenen ersten Material (46) bedeckten Regionen des Substrats bildet, falls das Substrat aus Silizium besteht.

10. Verfahren zur Herstellung einer Wanne eines ersten Leitfähigkeitstyps und von elektrischen Isolationszonen in einem halbleitenden Substrat (42) eines zweiten Leitfähigkeitstyps mit Hilfe der Implantation von drei Ionensorten, wobei diese Wanne bestimmt ist, wenigstens eine erste Komponente eines in dem Substrat ausgeführten integrierten Schaltkreises und Isolationszonen (60a, 62a) aufzunehmen, die an diese erste Komponente angrenzen und bestimmt sind, diese erst Komponente elektrisch von wenigstens einer zweiten aktiven Komponente des integrierten Schaltkreises zu isolieren, wobei dieses Verfahren die folgenden sukzessiven Verfahrensschritte aufweist:

1) das Aufbringen einer Schicht aus einem ersten Material (46) auf die Gesamtheit des Substrats (42),

2) das Ätzen dieser Schicht aus dem ersten Material (46), um das erste Material nur oberhalb der ersten und zweiten Zone (49, 50) des Substrats zurückzubehalten, in denen man jeweils die erste und zweite aktive Komponente ausführt,

3) Implantationen von Ionen einer dritten Sorte in die ersten nicht von verbliebenen ersten Material (46) bedeckten Regionen (64) des Substrats, wobei diese ersten Regionen vom zweiten Leitfähigkeitstyp sind,

4) das Herstellen einer Maske (50a) aus einem zweiten Material, das selektiv bezüglich des darunterliegenden Materials geätzt werden kann und das eine Öffnung aufweist, die die Ausmaße der herzustellenden Wanne (58a) bestimmt, wobei diese Öffnung (51a) gegenüber dem übriggebliebenen ersten Material (46), das sich über der ersten Zone (49) befindet, angeordnet ist und an jeder Seite über das erste Material herausragt,

5) das partielle Ätzen der zweiten Regionen (54a, 56a) des Substrats, die an die erste Zone (49) des Substrats angrenzen und nicht durch das verbliebene erste Material (46) und das zweite Material (50a) bedeckt sind, wodurch ermöglicht wird, die Regionen des Substrats zu beseitigen, die Ionen der dritten Sorte aufweisen und um die erste Zone angeordnet sind,

6) die Implantation von Ionen einer ersten Sorte in die erste Zone (49) des Substrats und in die zweiten Regionen (54a, 56a) des Substrats, wodurch lokal der Leitfähigkeitstyp des Substrats invertiert wird,

7) die Implantation von Ionen einer zweiten Sorte, die ermöglicht, den Leitfähigkeitstyp des Substrats zu ändern, und deren Eindringtiefe in das Substrat geringer ist als die der Ionen der ersten Sorte, in die Regionen (54a, 56a) des Substrats,

8) das Entfernen der Maske aus dem zweiten Material,

9) das Tempern des implantierten Substrats, um die Ionen um Substrat diffundieren zu lassen und die Wanne (58a) zu bilden,

10) das Bilden von Isolationszonen (60a, 62a) und

11) das Entfernen des ersten, verbliebenen Materials (46).

11. Verfahren nach Anspruch 1 bis 10, dadurch gekennzeichnet, daß man das Ätzen der zweiten Regionen des Substrats bis auf eine Tiefe (h′) ausführt, die gleich der Eindringtiefe der Ionen der dritten Sorte in das Substrat bei ihrer Implantation ist.

12. Verfahren nach einem der Ansprüche 10 oder 11, dadurch gekennzeichnet, daß das Substrat p-dotiertes Silizium ist und die Ionen der dritten Sorte Bordifluoridionen sind.

13. Verfahren nach Anspruch 12, dadurch gekennzeichnet, daß die Ionen der ersten Sorte Phosphorionen sind.

14. Verfahren nach Anspruch 12 oder 13, dadurch gekennzeichnet, daß die Ionen der zweiten Sorte Arsenionen sind.

15. Verfahren nach einem der Ansprüche 10 oder 11, dadurch gekennzeichnet, daß das Substrat n-dotiertes Silizium ist und die Ionen der dritten Sorte Arsenionen sind.

16. Verfahren nach Anspruch 15, dadurch gekennzeichnet, daß die Ionen der ersten Sorte Borionen sind.

17. Verfahren nach Anspruch 15, dadurch gekennzeichnet, daß die Ionen der zweiten Sorte Bordifluoridionen sind.

18. Verfahren nach einem der Ansprüche 1 bis 17, dadurch gekennzeichnet, daß das erste Material (46) Siliziumnitrid ist.

19. Verfahren nach einem der Ansprüche 1 bis 17, dadurch gekennzeichnet, daß das zweite Material (50) ein lichtempfindlicher Photolack ist.

20. Verfahren nach einem der Ansprüche 1 bis 19 angewandt auf die Herstellung eines integrierten MOS-Schaltkreises in einem Siliziumsubstrat, dadurch gekennzeichnet, daß man zwischen der Schicht aus dem ersten Material (46) und dem Substrat (42) eine Schicht aus Siliziumoxyd (44) anordnet die nicht von dem verbliebenen ersten Material (46) und dem zweiten Material (50, 50a) bedeckte Siliziumoxydschicht vor dem partiellen Ätzen des Substrats entfernt.

**Claims**

1. Method of manufacturing a well having a first type of conductivity a semi-conductor substrate (42) having a second type of conductivity, this well being intended to receive at least one active component of an integrated circuit formed in the said substrate, this method comprising the following successive stages:

(1) deposition of a layer consisting of a first material (46) over the entire substrate (42),

(2) etching of this layer of first material (46) so as to retain some of the first material only above the zone (49) of the substrate in which the said active component is to be formed,

(3) formation of a mask (50) consisting of a second material, which can be selectively etched with respect to the underlying material, comprising an opening (51) defining the dimensions of the well (58) to be formed, this opening (51) being situated opposite the remaining first material (46) and protruding on either side of the said first material,

(4) implantation of ions of a first kind simultaneously in the said zone (49) of the substrate and in regions (54, 56) of the substrate adjacent to the said zone and not masked by the remaining first material (46) and the second material (50), reversing locally the conductivity of the substrate,

(5) partial etching of the said regions (54, 56) of the substrate allowing removal of the regions of the substrate comprising ions of the first kind situated around the zone (49),

(6) implantation of ions of a second kind, allowing the type of conductivity of the substrate to be changed and the penetration of which in the substrate is less than that of the ions of the first kind, in the said regions (54, 56) of the substrate,

(7) elimination of the mask of second material (50),

(8) annealing of the implanted substrate so as to cause diffusion of the ions in the said substrate and form the well (58), and

9) elimination of the remaining first material (46).

2. Method according to claim 1, characterized in that etching of the regions (54a, 56a) of the substrate is performed over a height (h) equal to the depth of penetration of the ions of the first kind in the substrate, when they are implanted.

3. Method according to claim 1 or 2, characterized in that the ions of the first kind are ions of smaller size than the ions of the second kind.

4. Method according to any one of claims 1 to 3, characterized in that the substrate (42) being p-type silicon, the ions of the first kind are phosphorus ions.

5. Method according to claim 4, characterized in that the ions of the second kind are arsenic ions.

6. Method according to any one of claims 1 to 3, characterized in that the substrate (42) being n-type silicon, the ions of the first kind are boron ions.

7. Method according to claim 6, characterized in that the ions of the second kind are boron difluoride ions.

8. Method according to any one of claims 1 to 7, serving also for the manufacture of electrical insulation zones adjacent to the said active component, characterized in that the said insulation zones (60, 62) are formed between the stages (7) and (9).

9. Method according to claim 8, characterized in that the insulation zones (60, 62) are formed subsequent to annealing by thermal oxidation of the regions of the substrate not covered with the remaining first material (46), in the case of a silicon substrate.

10. Method of manufacturing a well having a first type of conductivity and electrical insulation zones in a semi-conductor substrate (42) having a second type of conductivity, by means of implantation of three kinds of ions, this well being intended to receive at least a first active component of an integrated circuit formed in the said substrate and the insulation zones (60a, 62a), adjacent to the said first component, being intended to insulate electrically this first component from at least a second active component of the said integrated circuit, this method comprising the following successive stages:

(1) deposition of a layer consisting of a first material (46) over the entire substrate (42),

(2) etching of this layer of first material (46) so as to retain some of the first material only above the first and second zones (49, 50) of the substrate in which the said first and second active components are to be respectively formed,

(3) implantation of ions of a third kind in first regions (64) of the substrate not covered with the remaining first material (46), these first regions having the second type of conductivity,

(4) formation of a mask (50a) consisting of a second material, which can be selectively etched with respect to the underlying material, comprising an opening defining the dimensions of the well (58a) to be formed, this opening (51a) being situated opposite the remaining first material (46) situated above the first zone (49) and protruding on either side of the said first material,

(5) partial etching of second regions (54a, 56a) of the substrate, adjacent to the first zone (49) of the substrate and not masked by the remaining first material (46) and the second material (50a), allowing removal of the regions of the substrate comprising ions of the third kind situated around the first zone (49),

(6) implantation of ions of a first kind, in the first zone (49) of the substrate and in the second regions (54a, 56a) of the substrate, reversing locally the conductivity of the substrate,

(7) implantation of ions of a second kind, allowing the type of conductivity of the substrate to be changed and having a depth of penetration in the substrate less than that of the first kind, in the said second regions (54a, 56a) of the substrate,

(8) elimination of the mask of second material (50a),

(9) annealing of the implanted substrate so as to cause diffusion of the ions in the said substrate and form the well (58a),

(10) formation of the insulation zones (60a, 62a), and

(11) elimination of the remaining first material (46).

11. Method according to claim 10, characterized in that etching of the second regions of the substrate is performed over a height (h') at least equal to the depth of penetration of the ions of the third kind in the substrate, when they are implanted.

12. Method according to claim 10 or 11, characterized in that the substrate being p-type silicon, the ions of the third kind are boron difluoride ions.

13. Method according to claim 12, characterized in that the ions of the first kind are phosphorus ions.

14. Method according to claim 12 or 13, characterized in that the ions of the second kind are arsenic ions.

15. Method according to claim 10 or 11, characterized in that the substrate being n-type silicon, the ions of the third kind are arsenic ions.

16. Method according to claim 15, characterized in that the ions of the first kind are boron ions.

17. Method according to claim 15, characterized in that the ions of the second kind are boron difluoride ions.

18. Method according to any one of claims 1 to 17, characterized in that the first material (46) is silicon nitride.

19. Method according to any one of claims 1 to 17, characterized in that the second material (50) is photosensitive resin.

20. Method according to any one of claims 1 to 19 applied to the manufacture of an MOS integrated circuit in a silicon substrate, characterized in that a layer of silicon oxide (44) is interposed between the layer of first material (46) and the substrate (42) and in that the regions of the layer of silicon oxide not masked by the remaining first material (46) and the second material (50, 50a) are eliminated before performing partial etching of the substrate.

FIG. 1

FIG. 2

EP 0 230 824 B1

FIG. 3